# EUROPÄISCHE PATENTSCHRIFT

(11) **EP 0 598 926 B1**
(45) Veröffentlichungstag und Bekanntmachung des Hinweises auf die Patenterteilung: **11.11.1998**
(21) Anmeldenummer: 92116183.2
(22) Anmeldetag: 22.09.1992
(51) Int. Cl.: G03F 1/00

(54) **Verfahren und Vorrichtung zur Herstellung von Flexodruckformen**
Process and apparatus for the manufacturing of flexographic printing plates
Procédé et appareil pour la fabrication de plaques d'impression flexographiques

(43) Veröffentlichungstag der Anmeldung: 01.06.1994
(60) Teilanmeldung: 97117794.4
(73) Patentinhaber: Schablonentechnik Kufstein Aktiengesellschaft, 6330 Kufstein (AT)
(72) Erfinder: Fischer, Hans, Ing., A-6300 Wörgl (AT)
(74) Vertreter: TER MEER STEINMEISTER & PARTNER GbR

(56) Entgegenhaltungen:
- EP-A- 0 492 351
- EP-A- 0 503 621
- DE-A- 3 146 946
- DE-A- 3 537 829
- DE-A- 4 117 127
- DE-C- 543 537
- DE-C- 566 066
- DE-C- 575 937
- GB-A- L18 415
- GB-A- 732 435
- US-A- 1 671 620
- US-A- 3 763 308
- PATENT ABSTRACTS OF JAPAN vol. 6, no. 218 (E-139)2. November 1982 & JP-A-57 124 437 (MITSUBISHI DENKI KK) 3. August 1982
- PATENT ABSTRACTS OF JAPAN vol. 5, no. 36 (P-51)(708) 7. März 1981 & JP-A-55 157 737 (HAMASAWA KOGYO K.K.) 8. Dezember 1980
- PATENT ABSTRACTS OF JAPAN vol. 12, no. 347 (M-743)19. September 1988 & JP-A-63 109 052 (CANON INC.) 27. Oktober 1986
- PATENT ABSTRACTS OF JAPAN vol. 009, no. 322 (M-440)18. Dezember 1985 & JP-A-60 155 471 (CANON KK) 15. August 1985
- PATENT ABSTRACTS OF JAPAN vol. 007, no. 261 (M-258)19. November 1983 & JP-A-58 142 863 (RICOH KK) 25. August 1983
- PATENT ABSTRACTS OF JAPAN vol. 14, no. 186 (M-962)16. April 1990 & JP-A-02 034 338 (CANON INC.) 5. Februar 1990
- PATENT ABSTRACTS OF JAPAN vol. 13, no. 161 (M-815)18. April 1989 & JP-A-63 317 376 (CANON INC) 26. Dezember 1988
- RESEARCH DISCLOSURE Nr. 185 , September 1979 , HAVANT GB Seite 478 S.C. PARANJPE ET AL. 'RANDOM DROP CHARGING FOR IN JET PRINTER'

## Beschreibung

Die Erfindung betrifft ein Verfahren zur Herstellung von Flexodruckformen.

Bei den genannten Flexodruckformen handelt es sich vorzugsweise um dünne Metallzylinder aus z. B. Nickel, die mit einem 2 bis 5 mm dicken Fotoelastomer beschichtet sind. Der Fotoelastomer wird durch Bestrahlung mit ultraviolettem Licht vernetzt und weist dann gegen Druckchemikalien und Lösemittel eine hohe Beständigkeit auf. Sein Elastizitätsmodul wird durch diese Behandlung wesentlich angehoben.

Es ist allgemein bekannt, derartige Flexodruckformen dadurch herzustellen, daß man den mit dem Fotoelastomer beschichteten Hohlzylinder durch einen darüber gelegten und rund um den Hohlzylinder gespannten Großfilm mit einer UV-Lichtquelle belichtet und die nicht belichteten Stellen des Fotoelastomers, die unvernetzt und dadurch auch weitaus geringer chemikalienbeständig geblieben sind, anschließend in einem Lösemittelbad auswäscht und auf diese Weise entwickelt. Anstelle des um den Hohlzylinder gelegten Großfilms wird manchmal auch ein tangential an den Zylinder gelegter und mit dessen Oberfläche synchron bewegter Film verwendet.

Beide Verfahren haben Nachteile. So muß in beiden Fällen ein sehr genau angefertigter Zylinder und ein ebenso genau gefertigter Film verwendet werden. Andernfalls kommt es an der Umfangsstoßstelle des Films zu einem freibleibenden Spalt oder zu einer Überlagerung des Musterbildes und somit zu entsprechenden Fehlern in der Gravur.

Um die Probleme bei der Übertragung eines Musters auf einen Druckzylinder zu beheben, wurde bereits vorschlagen (DE-C-0 543 537), das Muster zunächst auf eine lichtempfindliche Zinkplatte zu kopieren, diese mit einer Umdruckfarbe einzuwalzen und das Muster anschließend durch Vermittlung einer mit Gummibelag versehenen Trommel auf den mit einer lichtempflindlichen Schicht versehenen Druckzylinder zu übertragen, Auch hierbei bestehen jedoch die gleichen Probleme wie bei der Verwendung von Großfilmen, da die in Umfangsrichtung des Druckzylinders gesehenen Anfangs- und Endkanten des Musters exakt miteinander übereinstimmen müssen.

Weiter ist eine Vorrichtung zum Herstellen von lithographischen Druckplatten bekannt (EP-A-0 503 621) bei der eine flexible lithographische Druckplatte von einer Zuführstation einer Tintenstrahl-Beschichtungs-und Belichtungsstation zugeführt wird. In der Beschichtungs- und Belichtungsstation wird die lithographische Platte auf eine Trommel aufgezogen und mit ihren in Transportrichtung bzw. in Umfangsrichtung der Trommel gesehen vorderen und hinteren Kanten auf der Trommel festgeklemmt, so daß sie mit Hilfe der Trommel auf einer kreisförmigen Transportbahn zunächst an einer Tintenstrahldüse, die ein gewünschtes Muster zeilenförmig auf die Druckplatte aufspritzt, und anschließend an einer Belichtungseinheit vorbeigeführt wird. Nachdem Beschichten und Belichten wird die lithographische Platte dann wieder von der Trommel abgenommen, um in der üblichen Weise weiterbehandelt zu werden. Die Verwendung der Trommel zur Führung der lithographischen Druckplatte dient dabei lediglich zur Verkürzung der Baulänge der Beschichtungs-und Belichtungsstation.

Zum Aufbringen eines flüssigen Beschichtungsmaterial, z. B. einer fotografischen Emulsion auf einen Zylinder ist eine Vorrichtung bekannt (GB-A-732 435), bei der eine Sprühdüse parallel zur Längsachse des Zylinders verschoben wird, während sich der Zylinder um seine Zylinderachse dreht. Hierdurch läßt sich das flüssige Beschichtungsmaterial gleichmäßig und flächendeckend auf den Zylinder aufbringen.

Der Erfindung liegt die Aufgabe zugrunde, ein Verfahren zur Herstellung von Flexodruckformen zu schaffen, mit dem ein Muster sehr exakt und in kurzer Zeit auf einen mit einem Fotoelastomer beschichteten Zylinder aufgetragen werden kann, ohne das es an der Umfangsstoßstelle des Musters zu einem freibleibenden Spalt oder zu einer Überlagerung des Musterbildes kommt.

Diese Aufgabe wird durch das Verfahren nach Anspruch 1 gelöst.

Erfindungsgemäß wird also die zur Erzeugung des Musters erforderliche Abdeckflüssigkeit auf den mit noch unvernetzten Fotoelastomer beschichteten Zylinder entlang einer Schraubenlinie aufgespritzt, und zwar nur an jenen Stellen, die beim späteren Druckprozeß keine Druckfarbe übertragen sollen. Dabei werden die Drehlage des Zylinders und die Düsenstellung in Achsrichtung ständig registriert, um Positionen auf der Zylinderoberfläche bestimmen zu können, an denen in Übereinstimmung mit einem gewünschten Muster die Abdeckflüssigkeit aufgespritzt werden soll oder nicht.

Ein besonderer Vorteil des erfindungsgemäßen Verfahrens besteht darin, daß sich infolge des schraubenlinienförmigen Auftragens der Abdeckflüssigkeit zur Bildung des Musters an der Umfangsstoßstelle des Musterbildes weder freie Spalte noch Überlagerungen des Musterbildes bilden können, da die einzelnen in Umfangsrichtung verlaufenden, in Richtung der Zylinderachse nebeneinanderliegenden Musterlinien nahtlos aneinander angeschlossen werden.

Ein weiterer Vorteil besteht darin, daß die Drehrichtung des Zylinders und die Düsenstellung so gewählt werden können, daß die Relativgeschwindigkeit zwischen der Zylinderoberfläche und der Abdeckflüssigkeit beim Aufspritzen möglichst klein ist. um ein Zerspritzen der Abdecknüssigkeitstropfen beim Auftreffen auf die Zylinderoberfläche zu verhindern.

Darüber hinaus kommt das erfindungsgemäße Verfahren mit einem Minimum an Abdeckflüssigkeit aus, so daß es relativ kostengünstig durchgeführt werden kann.

Die Abdeckflüssigkeit weist eine relativ hohe Viskosität auf, so daß sichergestellt ist, daß Teile von ihr nicht wieder von der Oberfläche der Fotoelastomerschicht abfließen.

Nach einer Ausgestaltung der Erfindung kann die Abdeckflüssigkeit in mehreren Schichten aufgebracht werden, wodurch eine lichtdichtere Abdeckung der Fotoelastomerschicht erhalten wird. Eine ausreichend lichtdichte Abdeckung des Fotoelastomers ist notwendig, weil schon eine geringe Durchlässigkeit für UV-Licht Vernetzungen des Fotoelastomers bewirkt, welche zu einer wesentlich schlechteren Entwicklungsfähigkeit führen.

Aus diesem Grunde wird weiterhin vorgeschlagen, die Abdeckung mit Metallpigmenten durchzuführen, da diese gegenüber organischen Farbpigmenten UV-Licht wesentlich besser reflektieren. Es kommt also eine Metallpigmente enthaltende Abdeckflüssigkeit zum Einsatz, wobei allerdings zu beachten ist, daß bei der Notwendigkeit, sehr feine Stukturen zu übertragen, entsprechend fein vermahlte Metallpigmente eingesetzt werden müssen. Dies kann allerdings manchmal wegen ihrer leichten Oxidierbarkeit zu Problemen führen.

Daher wird weiter vorgeschlagen, als Abdeckflüssigkeit eine Silberhalogenidemulsion aufzubringen. Genauer gesagt wird nach einer Ausgestaltung der Erfindung eine Suspension aus Silberbromid, Silberjodid und/oder Silberchlorid in Gelantine oder Polyvinylalkohol als Abdeckllüssigkeit verwendet, weil solche Emulsionen auch bei feinster Verteilung des Silbers nicht explosionsgefährdet sind. Die Emulsion kann vorbelichtet sein, um den Entwicklungsprozeß zu verkürzen, und sie kann ferner bei Tageslicht aufgebracht werden, wodurch die Handhabung des erfindungsgemäßen Verfahrens sehr vereinfacht wird. Da die Emulsion nur innerhalb der lichtabzudeckenden Konturen aufgebracht wird und die Silberkeime nicht über die Ränder der aufgebrachten dünnen Abdeckschicht wachsen können, muß bei dem nachfolgenden Entwicklungsprozeß nur noch Wert auf eine möglichst optimale Lichtabdeckung gelegt werden. Die Reduktion von Silberhalogenidkristallen zu metallischem Silber kann also ohne Sorge im Hinblick auf die Kornvergröberung durch eine nachfolgende chemische Entwicklung erfolgen, die zu einer besonders guten Abdeckung gegenüber UV-Strahlen führt.

Nach einer anderen vorteilhaften Weiterbildung der Erfindung wird die Abdeckflüssigkeit unter einer Richtung aus der Düse ausgespritzt, die wenigstens annähernd parallel zur Erdanziehungskraft verläuft.

Kommen als Düsen beispielsweise elektrostatische Düsen zum Einsatz, so wird ein teilweise elektrostatisch aufgeladener Tropfennebel erzeugt, wobei die elektrisch aufgeladenen Tropfen aus ihrer Flugbahn abgelenkt und von den nichtgeladenen Tropfen auf diese Weise separiert werden. Die Tropfen unterliegen hierbei den Einflüssen der Schwerkraft und des Luftwiderstandes und beschreiben daher parabolische Bahnkurven während ihrer Bewegung durch die Düse. Wenn die Anfangsgeschwindigkeit des Flüssigkeitsstrahles, aus welchem die Tropfen entstehen, immer auf einen konstanten und gleichen Wert gehalten werden kann, dann ist eine parabolische Flugbahn nicht nachteilig. Muß aber mit Rücksicht z. B. auf rheologische Parameter der Abdeckflüssigkeit oder die einwandfreie Bedeckung des Zylinders eine andere Anfangsgeschwindigkeit vorgegeben werden, so resultiert hieraus auch eine andere Bahnparabel und die Selektion der unterschiedlich geladenen Tropfen wird schwieriger. Diese Verhältnisse können einheitlicher gestaltet werden, wenn die Bahnrichtung der Tropfen senkrecht gewählt wird, also die Düsenachse vertikal steht und die Düsen z. B. von oben nach unten die Abdeckflüssigkeit auf den Zylinder aufbringen. Auf diese Weise wird erreicht, daß die Bahn der Tropfen zunächst unbeeinflußt von der Schwerkraft bleibt und die Tropfen daher genau durch das Zentrum einer vor dem Ausspritzkanal liegenden Ringelektrode zur elektrostatischen Aufladung hindurchlaufen können, bevor sie schließlich durch eine nachfolgende Ablenkelektrode abgelenkt werden. Im Gegensatz dazu wird bei horizontalen Düsen die Tropfenbahn schon unmittelbar hinter dem Ausspritzkanal durch Schwerkraft beeinflußt, so daß es schwieriger ist, das Zentrum der Ringelektrode zu treffen.

Es hat sich als vorteilhaft erwiesen, das Aufspritzen der Abdeckflüssigkeit unter Begleitung eines sie umgebenden, laminaren Gasstromes vorzunehmen, beispielsweise unter Verwendung eines Luft- oder Inertgasstromes, um den Trocknungsvorgang der ausgespritzten Abdeckflüssigkeit zu beschleunigen. Der Gasstrom verhindert darüber hinaus, daß sich kleine Sekundärtröpfchen im Innern der Düse anlagern und diese ansonsten verschmutzen würden. Außerdem kann die Geschwindigkeit des laminaren Gasstroms so gewählt werden, daß sich einmal gebildete Tropfen auf ihrem Weg zum Träger bzw. Zylinder nicht mehr einander nähern können, wodurch die Bildung größerer Tropfen vermieden wird. Ferner kann der laminare Gasstrom auch gegenüber der Umgebungstemperatur eine erhöhte Temperatur aufweisen, wodurch sich das Trocknen der ausgespritzten Abdeckflüssigkeit noch weiter beschleunigen laßt. Nicht zuletzt kann der Zylinder wenigstens auch im Auftreffpunkt der Abdeckflüssigkeit beheizt werden, beispielsweise durch einen Wärmestrahler, um möglichst schnell eine feste Abdeckschicht auf der Zylinderoberfläche bzw. Oberfläche der Fotoelastomerschicht zu erhalten.

Die Erfindung wird nachfolgend unter Bezugnahme auf die Zeichnung näher beschrieben. Es zeigen:
**Figur 1** eine Vorrichtung nach einem ersten Ausführungsbeispiel zum Aufbringen einer Abdeckflüssigkeit auf die Oberfläche eines Zylinders,
**Figur 2** eine Vorrichtung nach einem zweiten Ausführungsbeispiel zum Aufbringen der Abdeckflüssigkeit auf die Oberfläche eines Zylinders,
**Figur 3** Aufbau und Anordnung einer ersten Düse zum Aufspritzen von Abdeckflüssigkeit,
**Figur 4** den detaillierten Aufbau der ersten Düse,
**Figur 5** Aufbau und Anordnung einer zweiten Düse zum Aufspritzen von Abdeckflüssigkeit,
**Figuren 6 bis 8** den detaillierten Aufbau der zweiten Düse und
**Figur 9** einen Querschnitt durch den Zylinder.

Nachfolgend werden verschiedene Ausführungsbeispiele der Erfindung im einzelnen unter Bezugnahme auf die Zeichnung näher beschrieben.

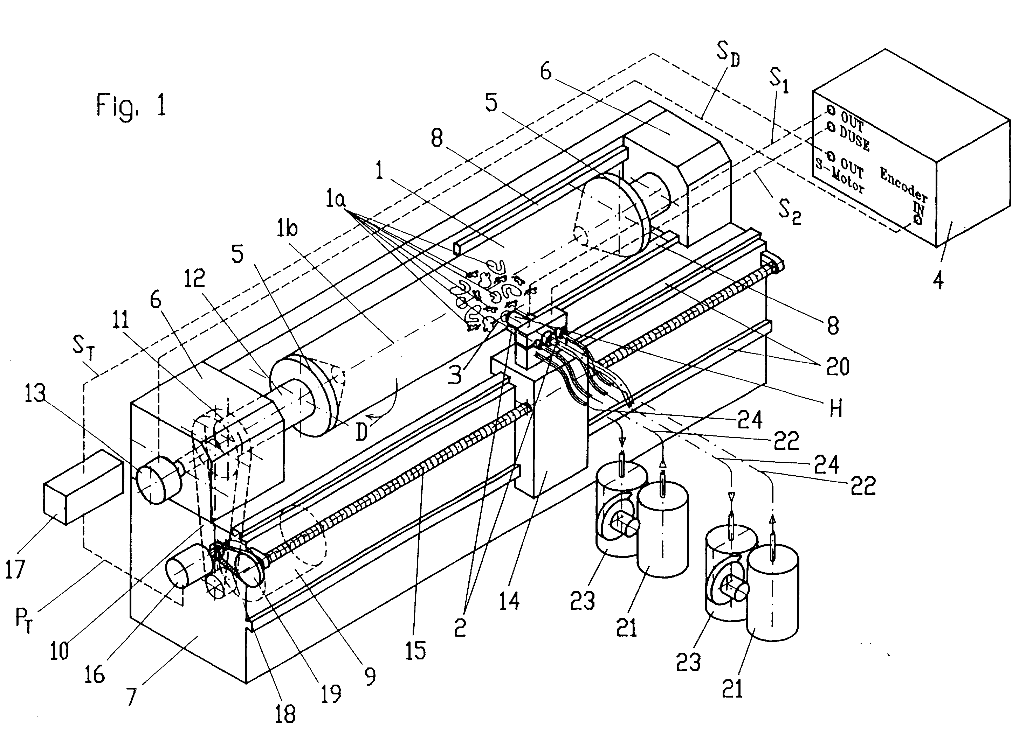

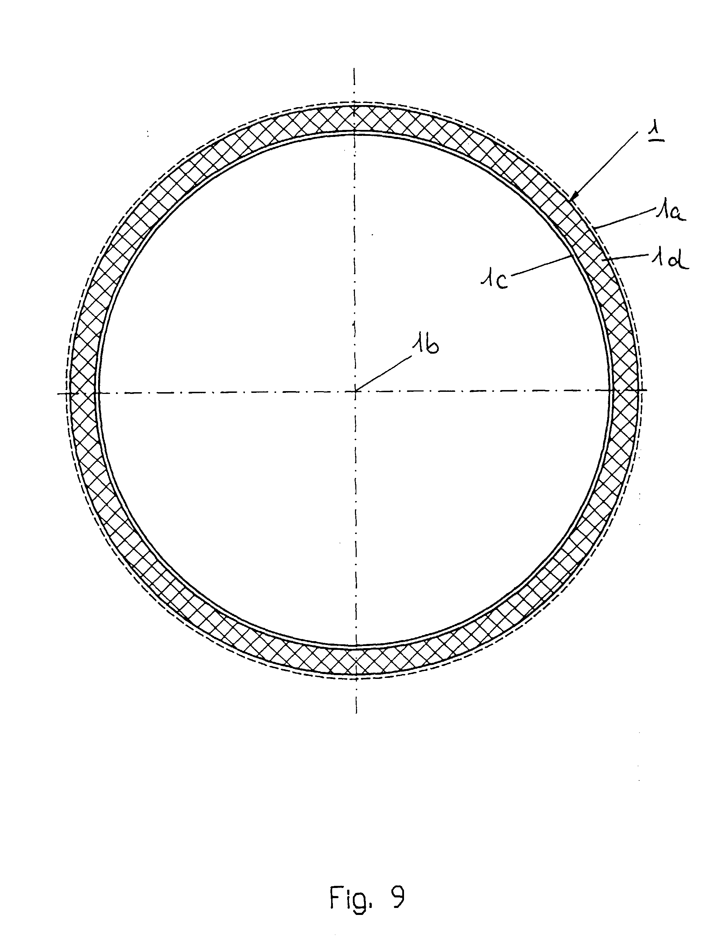

Ein erstes Ausführungsbeispiel einer erfindungsgemäßen Vorrichtung zeigt die Figur 1. Mit dem Bezugszeichen 1 ist ein Fotopolymerzylinder 1 bezeichnet, auf dessen Umfangsfläche ein Muster la aufgespritzt wird. Der Zylinder 1 rotiert um seine Zylinderachse 1b und besteht aus einem inneren Hohlzylinder 1c aus z. B. Nickel, der auf seiner Oberfläche mit Fotoelastomer 1d beschichtet ist, auf welchem das Muster la zu liegen kommt. Dies ist in Figur 9 dargestellt.

Durch eine oder mehrere Düsen 2 wird Farbe oder Lack als Abdeckflüssigkeit aufgespritzt. Hierbei wird ein aus den Düsen 2 ausgespritzter Strahl 3 der Abdeckflüssigkeit mittels eines Rechners 4 so gesteuert, daß die Abdeckflüssigkeit nur an jenen Stellen auf den Zylinder 1 aufgebracht wird, an welchen dieser musterbedingt unvernetzt bleiben muß und jene Stellen des Zylinders 1 unbedeckt bleiben, an welchen die Fotopolymeroberfläche des Zylinders 1 im nachfolgenden Verfahrensschritt vernetzt werden soll. Der Zylinder 1 wird zu diesem Zweck zwischen zwei synchron angetriebenen Endköpfen 5 aufgenommen und in drehende Bewegung versetzt, wobei die Drehrichtung mit D bezeichnet ist.

Um verschiedene Schablonen- bzw. Zylinderlängen zwischen den Endköpfen 5 aufnehmen zu können, ist beispielsweise der rechte Endkopf 5 in Richtung der Zylinderachse 1b des Zylinders 1 verschiebbar. Der Zylinder 1 wird zwischen den rechten und den linken Endkopf 5 gelegt und der rechte Endkopf 5 an den Zylinder 1 herangefahren. Der üblicherweise ausreichend leicht gestaltete Zylinder 1 kann unter Umständen auch schon durch die axial wirkende Spannkraft und die Reibung zwischen dem Zylinder 1 und dem linken angetriebenen Endkopf 5 in Drehung versetzt werden. Auch reicht die Steifigkeit des Zylinders 1 immer aus, um auch dem rechten Endkopf 5 über die wirkenden Reibkräfte die Drehbewegung mitzuteilen, wenn nur die Drehzahl des Zylinders 1 so langsam erhöht wird, daß das erforderliche Beschleunigungsmoment die Übertragungsfähigkeit des Zylinders 1 nicht überfordert. Beide Endköpfe 5 sind an Lagerböcken 6 drehbar montiert, wobei die Lagerböcke 6 auf einem Maschinenbett 7 angeordnet sind. Zur Führung des rechten Lagerbocks 6 in Figur 1 sind Führungsstangen 8 vorhanden, die z. B. auf dem Maschinenbett 7 befestigt sein können.

Der linke Endkopf 5 wird durch einen Motor 9 und einen Riemen 10 angetrieben. Dieser Riemen 10 umspannt ein Antriebsrad 11, das fest auf einer Achse 12 liegt, welche den linken Endkopf 5 trägt. Am anderen Ende der Achse 12 befindet sich ein inkrementaler Impulsgeber 13, der die Drehlage der Achse 12 bzw. des Zylinders 1 bestimmt und entsprechende Signale S_{D} an den Rechner 4 abgibt. Gleichzeitig werden die Düsen 2, die auf einem Bearbeitungstisch 14 befestigt sind, in Richtung der Zylinderachse 1b des Zylindersl langsam vorgeschoben, so daß ein dünner in Tropfen aufgelöster und aus Abdeckflüssigkeit bestehender Strahl, der aus den Düsen 2 austritt, entlang einer Schraubenlinie sehr geringer Steigung auf den Zylinder 1 auftrifft. Dem Bearbeitungstisch 14 wird seine Vorschubbewegung über eine Spindel 15 aufgeprägt, wobei diese Spindel 15 hierzu über einen Schrittmotor 16 angetrieben wird, der seine Schritt-Signale S_{T} ebenfalls vom Rechner 4 empfängt. Diese Schritt-Signale ST werden durch eine Treiberstufe 17 in Leistungsimpulse P_{T} umgesetzt. Die Drehung der Motorachse des Schrittmotors 16 wird über einen Riemen 18 und eine Riemenscheibe 19 auf die Spindel 15 übertragen. Diese durchragt den Bearbeitungstisch 14, der seinerseits auf Führungsschienen 20 am Maschinenbett 7 geführt ist.

Die Düsen 2 müssen mit einer für den späteren UV-Belichtungsvorgang geeigneten Abdeckflüssigkeit versorgt werden. Hierzu sind sie mit kleinen Druckbehältern 21 über Versorgungsleitungen 22 verbunden. In den Druckbehältern 21 steht die Abdeckflüssigkeit unter einem geringen Überdruck von etwa 1 bis 5 bar. Zweckmäßigerweise wird man für jede Düse 2 einen getrennten Druckbehälter 21 vorsehen, da Unterschiede in den Leitungswiderständen und die Notwendigkeit, die Auftragsmenge je Düse 2 getrennt einregeln zu können, unterschiedliche Ausgangsdrucke der Abdeckflüssigkeit bedingen. Es fällt bei jeder Düse 2 auch eine nicht unbeträchtliche Menge unverbrauchter Abdeckflüssigkeit an, die kontinuierlich abgesaugt und zurückbefördert werden muß. Hierzu sind Unterdrucktanks 23 vorgesehen, in welche über Rückleitungen 24 die unverbrauchte Abdeckflüssigkeit durch den in diesen Tanks herrschenden Unterdruck zurückbefördert wird. Die rezirkulierte Abdeckflüssigkeit, welche auf Grund des durchlaufenen Prozesses Verdünnungsmittel verloren hat, kann nach einer Aufbereitung wiederum dem Auftragsprozeß als Abdeckflüssigkeit zugeführt werden. Um eine entsprechende Dicke der Abdeckschicht 1a auf dem Zylinder 1 zu erzielen, sind die Düsen 2 mehrfach angeordnet, im vorliegenden Fall zweifach. Sie sind in Richtung der Zylinderachse 1b bzw. Schablonenachse voneinander beabstandet, um der Abdeckflüssigkeit vor dem zweiten Auftrag Zeit zu einem zumindest leichten Trocknen zu geben. Diese Trocknung kann durch Aufblasen von Warmluft unterstützt werden, oder durch Erzeugung entsprechender Wärmestrahlung. Hierzu kann auf dem Bearbeitungstisch 14 eine entsprechend ausgebildete Heizeinrichtung H montiert sein.

Im Prinzip kann man die Düsen 2 auch in Umfangsrichtung des Zylinders 1 versetzen, jedoch führt dies zu einer erschwerten Handhabung des Beschichtungsvorganges, wenn aufeinanderfolgende Zylinder 1 unterschiedlichen Durchmessers beschichtet werden sollen.

Die Düsen 2 sind vorzugsweise als Elektrostatikdüsen ausgebildet, denen jeweils ein Steuersignal S₁, S₂ vom Rechner 4 zugeführt wird, um bei Empfang eines Steuersignals die Abdeckflüssigkeit auszuspritzen.

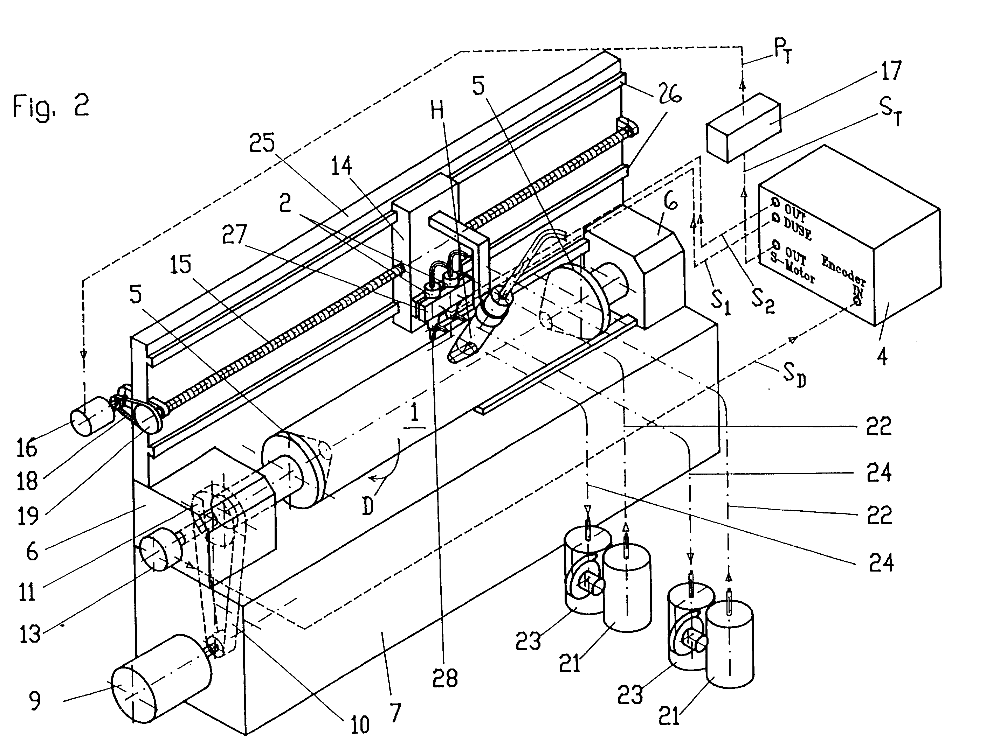

Die Figur 2 zeigt eine im Prinzip gleiche Vorrichtung wie in Figur 1, wobei gleiche Elemente mit den gleichen Bezugszeichen versehen sind. Abweichend von Figur 1 ist hier der Bearbeitungstisch 14 aber an einer hinteren Trägerwand 25 auf Führungsschienen 26 in Axialrichtung des Zylinders 1 verschiebbar gelagert. An dieser hinteren Führungswand 25 sind ebenfalls die Spindel 15 und der Schrittmotor 16 mit Spindelantrieb 18 und 19 befestigt. An der dem Zylinder 1 zugwandten Vorderseite des Bearbeitungstisches 14 befindet sich eine Halteeinrichtung 27, die zum Festklemmen zweier Düsen 2 dient, welche nunmehr mit ihren Düsenachsen vertikal stehen, also senkrecht zur ebenen Oberfläche des Maschinenbettes 7. Die Düsenöffnungen 28 weisen dabei nach unten.

Auf diese Weise ist es möglich, die Tropfen des Abdeckmaterials zunächst parallel zur und in Gravitationsrichtung auszuspritzen, bevor sie auf die Oberfläche des Zylinders 1 auftreffen.

Bei dem Verfahren nach der Erfindung wird die Abdeckflüssigkeit in feinsten Tropfen aufgebracht werden, um ein hinreichend hohes Auflösungsvermögen bei der Erzeugung des Druckmusters auf der Oberfläche des Zylinders 1 zu erzielen. Dabei weist die Flüssigkeit eine hohe Viskosität auf, um einen ausreichenden Anteil von Festsubstanz (Gelantine. Polyvinylalkohol) und Abdecksubstanz (z. B. Metallpigmente, Silberhalogenide) bei relativ kleiner Tropfengröße mitführen zu können. Darüber hinaus erfolgt das Aufspritzen der Abdeckflüssigkeit mit einer sehr hohen Tropfenfrequenz.

Dies alles ist möglich durch den Einsatz sogenannter elektrostatisch wirkender Düsen, bei welchen ein Flüssigkeitsstrahl durch eine sehr hochfrequente Schwingung, beispielsweise einer Rohrwand, regelmäßig in Tropfen zerfallen gelassen wird und bei welchen die Tropfen anschließend elektrisch geladen werden und in einem Elektrostatikfeld je nach Ladungszustand abgelenkt oder nicht abgelenkt werden. Herkömmliche Düsen dieser Art sindjedoch nicht geeignet, die für das Beschichten von Zylindern erforderlichen hochviskosen Abdeckflüssigkeiten zu verarbeiten. Während bei niederviskosen Flüssigkeiten bereits geringe Anfangsstörungen genügen, um den Flüssigkeitsstrahl durch die Wirkung der Oberflächenspannung der Flüssigkeit unmittelbar hinter dem Düsenaustritt rasch in Einzeltropfen zerfallen zu lassen, würden bei den für die Schablonenabdeckung notwendigen hohen Viskositäten Strahllängen von 0,5 - 1,0 m entstehen, bevor der erste Tropfen durch Strahleinschnürung entsteht. An der Stelle der ersten Tropfenbildung muß eine ringförmige Ladeelektrode mit sehr kleinem Durchmesser angeordnet werden. Auf Grund der unvermeidlichen Luftwirbel ist bei solchen Abständen weder der Ort der ersten Tropfenbildung genau festlegbar noch der Verlauf des Strahles, so daß durch eine so kleine ringförmige Ladeelektrode nicht mehr hindurchgetroffen werden kann. Bei der Erfindung kommen daher Elektrostatikdüsen mit geänderter Bauweise zum Einsatz.

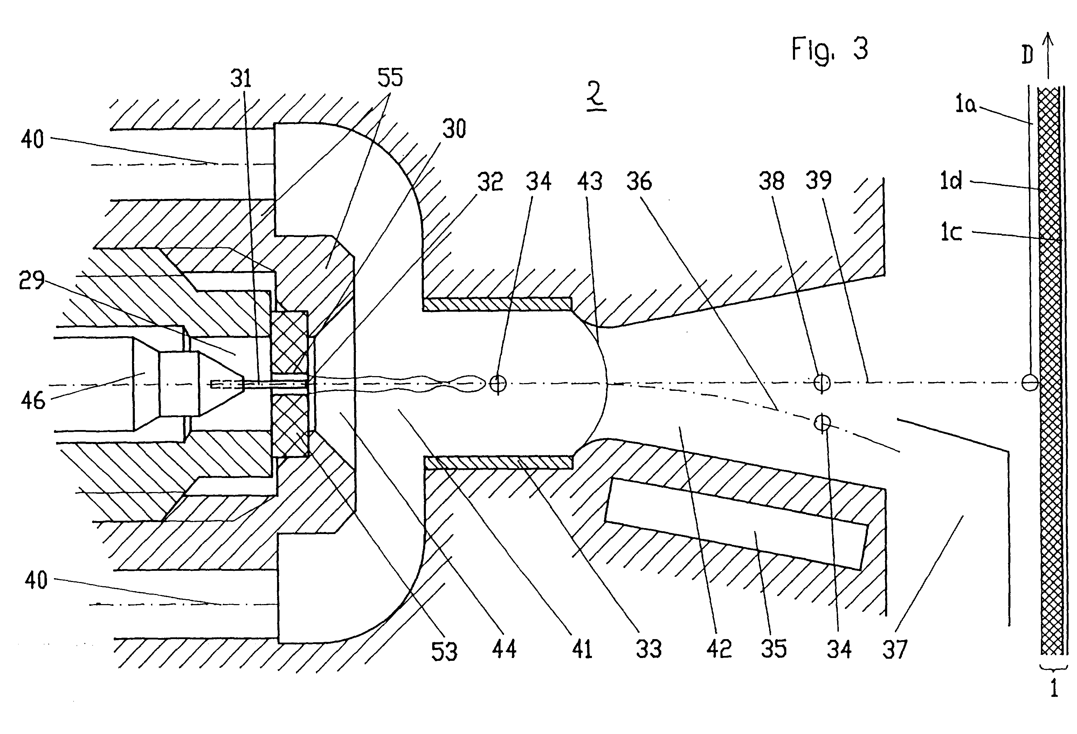

Die Figur 3 zeigt den Aufbau einer derartigen Elektrostatikdüse 2.

In einer kleinen Druckkammer 29 steht die Abdeckflüssigkeit, die aus den in Figur 1 gezeigten Druckbehältern 21 herangeführt wird, unter Überdruck. Von dort tritt sie kontinuierlich durch eine Bohrung 30 aus. In der Bohrung 30 sorgt eine dünne Nadel 31, die durch Ultraschall zu hochfrequenter Schwingung in Nadellängsrichtung angeregt wird, für regelmäßige Störungen in jenem ringförmigen Strömungskanal, der durch die Nadel 31 und die Bohrung 30 gebildet wird. Außerdem verhindert die Schwingungsbewegung der Nadel 31 auch ein Verstopfen der Bohrung 30 z. B. durch kleine Partikel. Bei jeder Schwingungsbewegung der Nadel 31 in Richtung des Austritts, zu welchem die Abdeckflüssigkeit auf Grund des Druckgefälles strömt, wird die Abdeckflüssigkeit zufolge ihrer Zähigkeit mit der Nadelwand mitgenommen und so zusätzlich beschleunigt und bei jeder entgegengesetzt gerichteten Schwingungsbewegung wird sie auf die gleiche Weise verzögert. Auch die Bewegung der Stirnfläche 32 der Nadel 31 erbringt einen in der Wirkung gleichgerichteten Effekt. Diese Stirnflächenbewegung der Nadel 31 ist bei den hier vorliegenden Suspensionen von kleinen Pigmenten oder Kristallen in zäher Flüssigkeit von besonderem Vorteil, da bei entsprechend hohen Beschleunigungswerten der Stirnfläche 32 die Festkörperchen abgeschleudert werden, was zu einer besonders starken Unterstützung des Einschnürvorgangs führt. Man hat es durch Dimensionierung des Durchmessers der Nadel 31 und der Bohrung 30 in der Hand, die Beschleunigungs- bzw. die Verzögerungseffekte ausreichend groß zu gestalten. Je größer der Durchmesser der Nadel 31 und je kleiner der Durchmesser der Bohrung 30 sind, desto stärker sind die Beschleunigungs- und damit die Störungseffekte. Aus den so herbeigeführten starken Störungen ergeben sich ausgeprägte, der Schwingungsfrequenz entsprechende regelmäßige Einschnürungen des die Bohrung 30 verlassenden Flüssigkeitsstrahls, die außerhalb der Bohrung 30 zufolge der Oberflächenspannung der Flüssigkeit weiter fortgebildet werden und so zu einer raschen Tropfenbildung führen. Damit die entstandenen Tropfen elektrostatisch aufgeladen werden können, ist eine Ringelektrode 33 vorgesehen, die im Durchmesser kleingehalten wird, weil dann schon bei niedrigen Spannungen eine ausreichende Aufladung der Tropfen erreicht werden kann. Es wird angestrebt, mit einer Spannung von 100 - 200 V arbeiten zu können. Diese Spannung muß im Augenblick des Tropfenabrisses an der Ringelektrode 33 anliegen. Spannungen dieser Größe lassen sich noch bequem mit hohen Frequenzen durch Transistoren schalten. Zum Zeitpunkt des Abrisses des Tropfens vom noch zusammenhängenden Strahl muß dieser auf einem 0 - Spannungspotential gegenüber der Ringelektrode 33 gehalten werden, damit auf dem abreißenden Tropfen eine negative Ladung verbleibt, und außerdem muß der Abriß im Bereich der Ringelektrode 33 erfolgen. Für die elektrische Verbindung mit der Druckkammer 29, die dauernd auf Erdpotential (= 0 V) gehalten wird, muß die innere Leitfähigkeit der Abdeckflüssigkeit sorgen. Daher ist es äußerst zweckmäßig, für die Abdeckflüssigkeit eine wässrige Suspension von Kristallen oder eine wässrige Suspension von Pigmenten zu wählen. Die Ringelektrode 33 wird im Durchmesser kleingehalten, wodurch hohe Feldstärken bereits bei niedrigeren Schaltspannungen erreicht werden. Damit der aus der Bohrung 30 austretende Flüssigkeitsstrahl das Zentrum der Ringelektrode 33 mit möglichst großer Sicherheit trifft, wird diese Ringelektrode 33 so nahe wie möglich an den Austritt der Bohrung 30 herangeführt. Der Strahl muß an dieser Stelle gerade beginnen, in Tropfen zu zerfallen. Die Treffsicherheit des Ringelektrodenzentrums wird durch eine vertikale Strahlführung, wie bereits im Zusammenhang mit der Figur 2 erwähnt, wesentlich vergrößert, wobei für den notwendigen raschen Strahlzerfall entsprechend stark ausgeprägte Anfangseinschnürungen des aus der Bohrung 30 austretenden Flüssigkeitsstrahles sorgen, die durch eine entsprechend starke Schwingung der Nadel 31 erzwungen werden.

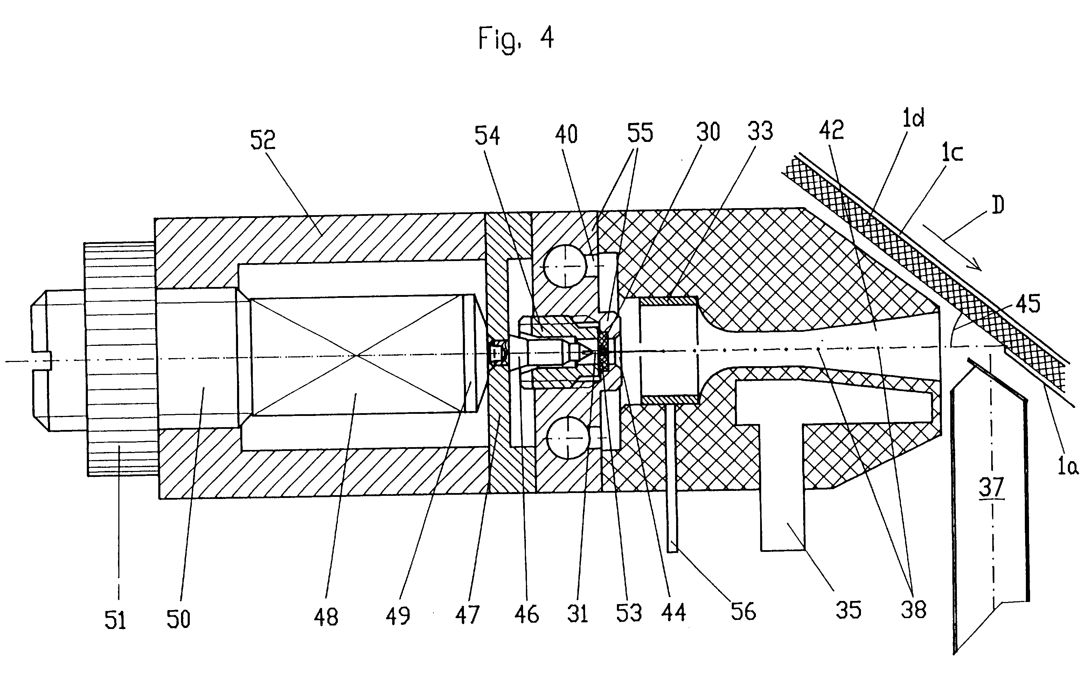

Die aufgeladenen Flüssigkeitstropfen, die hier das Bezugszeichen 34 tragen, werden anschließend durch die Wirkung eines über eine Elektrode 35 aufgebrachten Gleichspannungsfeldes auf einer gekrümmten Bahnlinie 36 in einen Fänger 37 geleitet. Von dort gelangen sie über die in Figur 1 erwähnten Rückleitungen 24 in die ebenfalls dort gezeigten Unterdrucktanks 23. Die nichtgeladenen Flüssigkeitstropfen 38 werden durch dieses Gleichspannungsfeld nicht abgelenkt und entsprechend setzen diese ihren Weg nahezu geradlinig entlang der Bahnlinie 39 fort, um schließlich auf den Zylinder 1 zu treffen. Der Zylinder 1 weist hier eine zur Bahn 39 der auf dieses auftreffenden, ungeladenen Tropfen 38 senkrechte Lage auf. Es kann aber durchaus zweckmäßig sein, den Zylinder 1 gegenüber einer solchen Lage zu neigen, was im Zusammenhang mit der nächsten Figur 4 gezeigt wird. Die Abdeckflüssigkeit muß in ausreichendem Maße Feststoffe transportieren, um nach Eintrocknen auf dem Zylinder 1 einen gut lichtabdeckenden Film zu bilden. Dies bedingt eine hohe Viskosität. Die hohe Zähigkeit hilft ferner, daß nach der Aufbringung der Abdeckflüssigkeit auf dem Zylinder 1 diese trotz der wirkenden Fliehkraft am Auftreffort verbleibt und auch nicht auf Grund der hohen Auftreffgeschwindigkeit in noch kleinere Tröpfchen zerspritzt.

Damit die Ringelektrode 33 auch während langer Betriebszeiten sauber bleibt, wird eine kombinierte Flüssigkeits- und Luft- oder Inertgaszufuhr in den Bereich der Ringelektrode 33 durchgeführt. Knapp vor Beginn des Spritzbetriebs wird durch Bohrungen 40 zunächst Flüssigkeit eingeleitet, um die Ringelektrode 33 zu reinigen. Anschließend wird diese durch die gleichen Bohrungen 40 trocken geblasen, etwa durch trockene, erwärmte Luft oder ein Inertgas. Die gleiche Ausgestaltung der Düse wird zusätzlich genutzt, um ein Eintrocknen der dünnen Bohrung 30 während längerer Arbeitspausen zu verhindern. In diesem Fall wird durch die Bohrungen 40 der anschließende Luftraum 41 vor der Bohrung 30 und innerhalb der Ringelektrode 33 mit Spülflüssigkeit gefüllt. Diese Spülflüssigkeit wird unter einem sehr geringen Überdruck gehalten (etwa 10 bis 20 mm Wassersäule), wodurch sich noch innerhalb des Düsenkanals 42 ein Flüssigkeitsmeniskus 43 ausbildet, der über längere Zeit bestehen kann, und der ein Austreten von Flüssigkeit aus dem Düsenkanal 42 verhindert. Diese Befüllung schützt die dünne Bohrung 30 vor dem Eintrocknen. Um der Flüssigkeit einen möglichst guten Zutritt zu der Bohrung 30 zu ermöglichen, kann eine kegelförmige Ansenkung 44 vorgesehensein. Durch sie öffnet sich die Bohrung 30 in den Düsenkanal 42 in Richtung der Ringelektrode 33. Es kann aber auch zweckmäßig sein. die Spülflüssigkeit nicht in Kontakt mit der Abdeckflüssigkeit innerhalb der Bohrung 30 treten zu lassen, um letztere nicht zu verdünnen. In diesem Fall entfällt die konische Ansenkung 44, und es findet sich an dieser Stelle nur ein entsprechend klein gehaltener zylindrischer Bohransatz. Die Spülflüssigkeit wird dann auch in dieser Bohrung einen Meniskus bilden, ähnlich dem Meniskus 43. Einen ebensolchen bildet die Abdeckflüssigkeit am Ausgang der Bohrung 30. Zwischen beiden Menisken befindet sich dann ein kleiner Luftraum, der dank seines kleinen Volumens rasch mit dampfförmigen Molekülen der leicht abdampfbaren Komponenten des Abdecklackes und der Spülflüssigkeit gesättigt wird. Eine weitere Abdunstung dieser Komponenten aus dem Abdecklack ist dann nicht mehr möglich, so daß ein Eintrocknen verhindert wird ohne die Gefahr, daß die Abdeckflüssigkeit durch Spülflüssigkeit verdünnt wird.

Die Düse 2 wird auch während der Ausbringung von Abdeckflüssigkeit auf den Zylinder 1 von Luft durchströmt. Dadurch hält die aus den Bohrungen 40 austretende Trockenluft kleine Sekundärtröpfchen von der Ringelektrode 33 ab und diese somit sauber. Solche Sekundärtröpfchen entstehen gleichzeitig mit den Haupttropfen bei dem Zerfall des aus der Bohrung 30 austretenden Flüssigkeitsstrahls. Wegen der Kleinheit und der geringen Masse dieser Sekundärtröpfchen können diese durch den Abschnürungsvorgang der Haupttropfen an die Ringelektrode 33 geschleudert werden. Würden sich dort Tropfenansätze bilden, dann könnte mit der Zeit die einwandfreie Funktion der Elektrode in Frage gestellt werden. Ein weiterer Effekt ergibt sich bei der Durchströmung des diffusorartigen Kanals 42.

Hier sollte die Fluggeschwindigkeit der Tropfen zwar etwas aber nicht zu stark verzögert werden, da sich diese erst nach dem Auftreffen auf dem Sieb 1 berühren dürfen. Eine Berührung der Flüssigkeitstropfen noch innerhalb des Düsenkanals 42 würde zur sofortigen Bildung von großen Tropfen führen, die wiederum wegen des spezifisch geringeren Luftwiderstandes weitere Normal-Tropfen einfangen und in Summe führen diese Vorgänge zu einer Verfälschung des elektrisch aufgeprägten Musterbildes. Diese Erscheinung kann dann verhindert werden, wenn die Tropfen auf ihrer Flugbahn innerhalb des Düsenkanals 42 von einer laminaren Luftströmung eingehüllt werden, die eine hierzu geeignete Strömungsgeschwindigkeit aufweist. Durch eine solche und z. B. erwärmte Luftströmung kann auch eine Vortrocknung der Einzeltropfen erreicht werden. Dies bringt Vorteile, wenn der Tropfen auf den Zylinder 1 aufschlägt. Durch eine Vortrocknung läßt sich die Tropfenviskosität erhöhen und außerdem die Größe der Tropfen verringern. Dadurch wird ein Zerplatzen der Tropfen in viele kleine Einzeltropfen beim Auftreffen auf den Zylinder 1 und die Ausbildung einer entsprechend unscharfen Lackkontur vermieden. Für eine ausreichende Vortrocknung ist allerdings eine verhältnismäßig große Länge des Düsenkanals 42 erforderlich, was insbesondere bei parallel zum Gravitationsfeld verlaufender Achse des Düsenkanals 30 möglich ist, also bei vertikaler Düsenachse.

Die Figur 4 zeigt den Gesamtaufbau der Düse nach Figur 3. Es gelten dabei die gleichen Bezugszeichen wie in Figur 3. Die Auftreffrichtung der Tropfen 38 auf den Zylinder 1 ist hier nicht mehr senkrecht, sondern liegt unter einem Winkel 45. Dies hilft, die Tropfen mit vermindeter Relativgeschwindigkeit auf die Oberfläche des Zylindersl auftreffen zu lassen und so die Gefahr des Zerplatzens der Tropfen zu mindern und ein viskositätsabhängiges Fließen der Tropfen auf dieser Oberfläche zu unterdrücken. Die Nadel 31 ist in einem Nadelhalter 46 gefaßt, der als Stufenhorn ausgebildet ist, d. h. der Durchmesser des Nadelhalters 46 nimmt zur Spitze der Nadel 31 hin ab. Dies verstärkt die in den Nadelhalter 46 eingeleitete Amplitude der hochfrequenten mechanischen Schwingung, so daß die Nadel 31 im Bereich der Bohrung 30 mit maximaler Amplitude schwingt. Der Nadelhalter 46 ist fest in einer Membran 47 gefaßt und diese wird durch ein Piezoelement 48 zu der hochfrequenten Schwingung angeregt. Ein Druckstück 49 leitet diese Schwingung an die Membran 47 weiter, wodurch die in der Druckkammer 29 befindliche Flüssigkeit auch durch die Membran 47 selbst druckbeaufschlagt wird. Um dies zu gewährleisten, müssen die Zuleitungen zur Druckkammer 29 entsprechend dünn ausgelegt sein. Bei entsprechender Ausbildung des Druckstückes 49 kann bereits hier eine Vorverstärkung der Schwingungsamplitude auf mechanischem Weg erreicht werden. Das Piezoelement 48 wird durch nicht mehr dargestellte Versorgungsleitungen mit einer der Eigenfrequenz der Düsenanordnung entsprechenden hochfrequenten Sinus- oder Rechteckspannung angeregt. Da das Piezoelement 48 sandwichartig aus sehr vielen dünnen Schichten zusammengesetzt ist, genügen bereits geringe elektrische Spannungen, um heftige Kontraktionen bzw. Elongationen insbesondere im Bereich der Eigenfrequenz der Gesamtanordnung zu erzeugen. Das Piezoelement 48 wird statisch in seiner Längsrichtung durch eine Druckschraube 50 vorgespannt, und eine Kontramutter 51 sichert diese Schraubeneinstellung. Ein Gehäuse 52 schließt statisch und dynamisch den Kraftfluß aller Einzelbauteile. Die Bohrung 30 der Düse 2 ist in einem Saphirplättchen 53 ausgeführt, welches von einer Schraube 54 in eine Halterung 55 gepreßt und auf diese Weise dort fixiert wird. Durch die Wahl des Bohrungsmaterials Saphir wird die durch die Nadelschwingung bedingte Gefahr des Verreibens oder Verschweißens der Nadel 31, die aus einem metallischen Material besteht, mit der Bohrungswandung, ggf. unter Miteinbeziehung der von der Flüssigkeit mitgeführten Metallpigmente, weitgehend gemindert. Saphir als Bohrungsmaterial bringt auch dann wesentliche Vorteile, wenn die Abdeckflüssigkeit Kristalle enthält, die bei einem metallischen Bohrungsmaterial durch Abrasion oder Erosion einen hohen Verschleiß verursachen würden.

Es sei noch darauf hingewiesen, daß die Ringelektrode 33 mit einer Zuleitung 56 verbunden ist, um erstere mit einem elektrischen Potential über die Zuleitung 56 versorgen zu können.

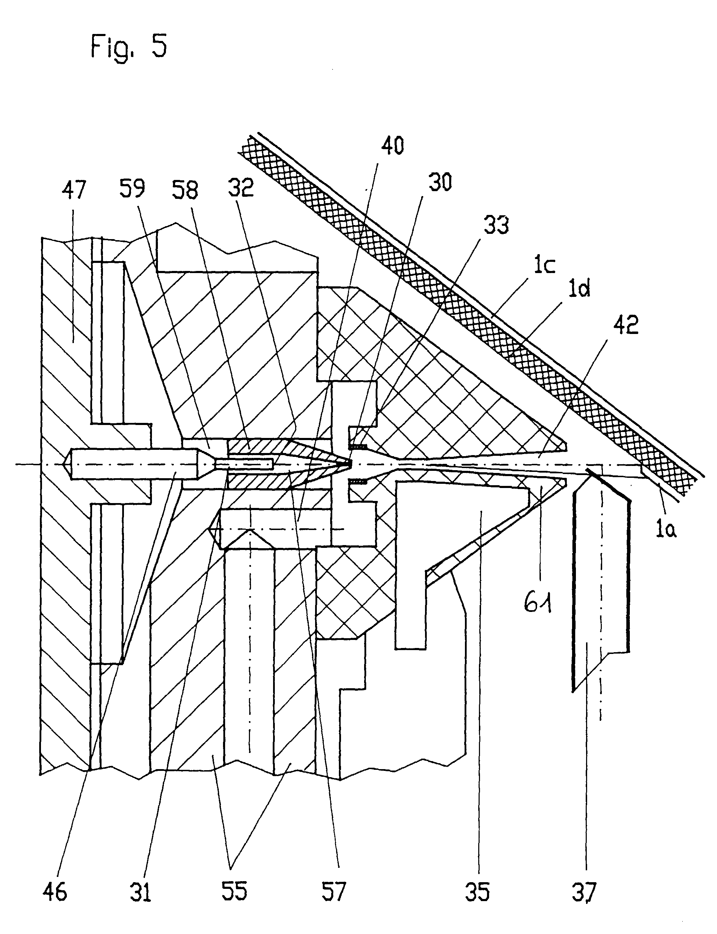

Eine weitere Ausführungsform einer elektrostatischen Düse zur Durchführung des erfindungsgemäßen Verfahrens ist in Figur 5 gezeigt. Auch hier sind die gleichen Elemente wie in den Figuren 3 und 4 mit den gleichen Bezugszeichen versehen und werden nicht nochmals erläutert. Die Bohrung 30 ist bei diesem Ausführungsbeispiel so klein, beispielsweise im Enddurchmesser 17 µm, daß sie nicht mehr von der Nadel 31 in ihrer ganzen Länge durchsetzt werden kann. Die Nadel 31 reicht daher nur bis in die Nähe der engsten Bohrungsstelle. Die Wirkung der Nadel 31 ist aber ähnlich der Wirkung, die früher beschrieben wurde. Eine Schwingungsbewegung der Nadel 31 in Richtung zum Düsenaustritt steigert sowohl auf Grund der Wandschubkräfte als auch auf Grund der Verdrängungswirkung der Nadelstirnfläche 32 den Druck im Düseninnenraum 57. Die entsprechende Rücklaufbewegung der Nadel 31 bewirkt eine Druckminderung. Hierdurch werden wiederum starke Störungen dem austretenden Flüssigkeitsstrahl aufgeprägt und dieser zeigt eine starke Neigung zum geregelten und raschen Zerfall. Die Bildung der Einzeltropfen findet im Bereich der Ringelektrode 33 statt, die auch hier mit einer geeigneten Zuleitung zum Anlegen eines elektrostatischen Potentials versehen ist. Der Düseninnenraum 57, in welchem sich die Nadel 31 bewegt, wird durch einen Düsenkörper 58 erhalten, der aus Hartmetall oder Keramik hergestellt ist. Dieser Düsenkörper 58 ist in eine Bohrung 59 der Halterung 55 eingesetzt, wobei der Nadelhalter 46 noch teilweise in die Bohrung 59 hineinragen kann.

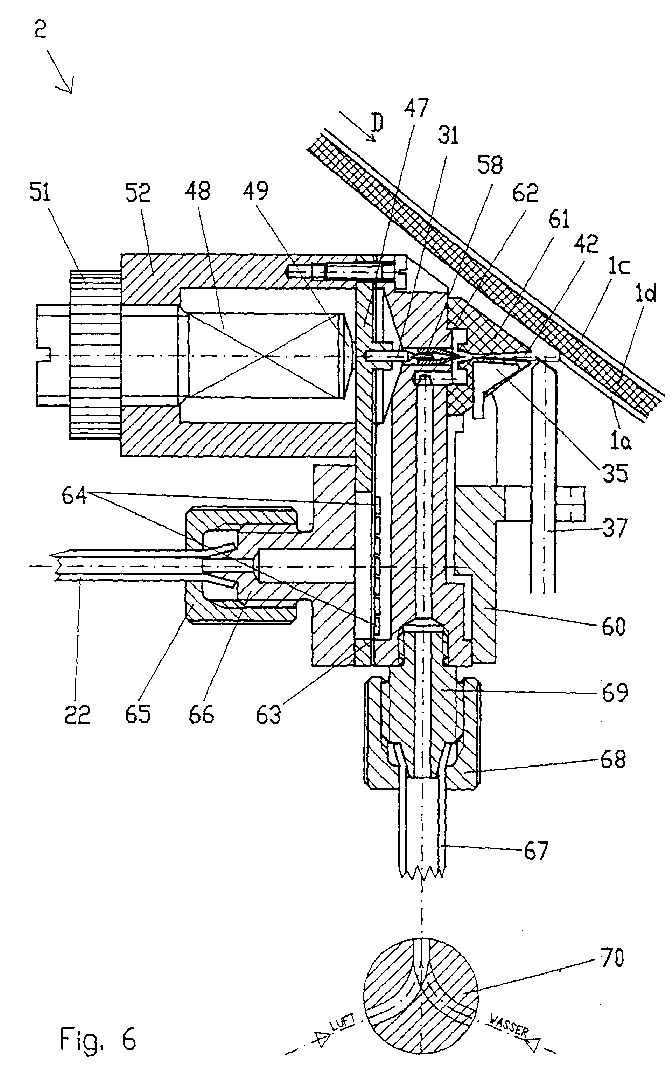

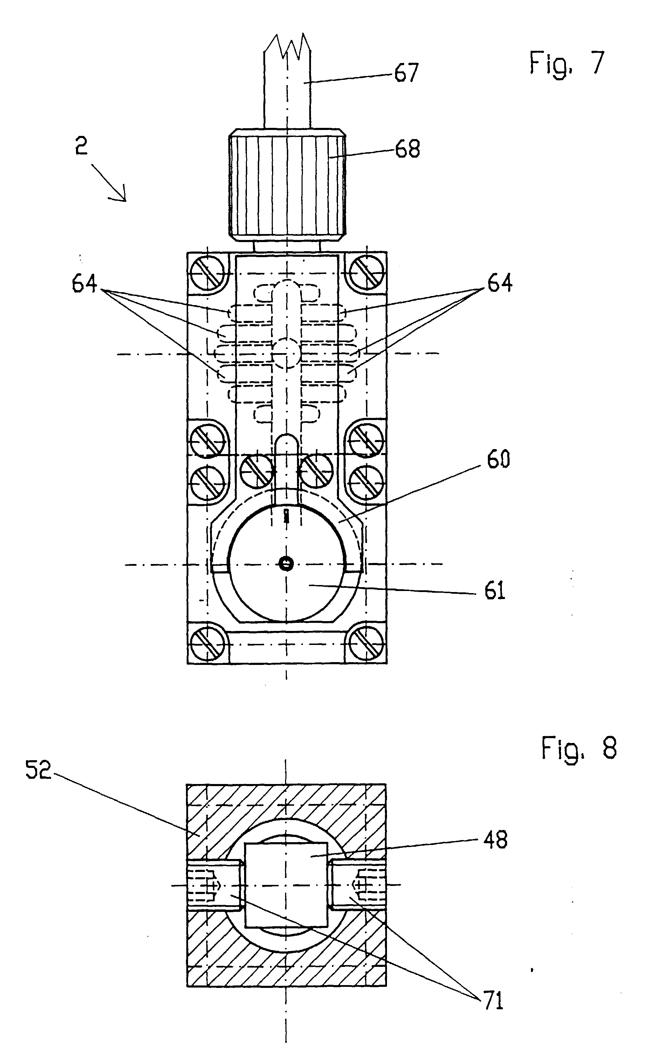

In den Figuren 6, 7 und 8 ist der Gesamtaufbau der Düse nach Fig. 5 dargestellt. Die Figur 6 zeigt den Schnitt durch einen Aufriß der Düse, die Figur 7 den Kreuzriß und die Figur 8 einen Querschnitt durch die Düse. Es sind wiederum gleiche Elemente wie in den Figuren 3 bis 5 mit den gleichen Bezugszeichen versehen und werden nicht nochmals beschrieben.

Ein Halter 60 preßt ein Mundstück 61, in welches die Ablenkelektrode 35 eingegossen ist, gegen den Düsengrundkörper 62. Der Düsenkanal 42 verläuft durch das Mundstück 61 hindurch und ist eingangsseitig mit der Ringelektrode 33 umgeben. Sie wird ebenfalls durch das Mundstück 61 getragen. Die schwingende Membran 47 befindet sich zwischen dem Gehäuse 52 und dem Düsengrundkörper 62. Dabei ist die schwingende Membran 47 zwischen Gehäuse 52 und Düsengrundkörper 62 eingespannt, wobei sie durch ein etwa 0,5 bis 1,0 mm dickes Stahlplättchen gebildet wird, welches wegen der besonderen Art der Einspannung nur in einem Umgebungsbereich der Nadel 31 Biegeschwingungen ausführen kann. Im darüberhinausragenden Bereich wird diese Membran 47 als Klemmelement für ein Mikrosieb 63 verwendet. Die relativ große Dicke der Membran bedingt Eigenfrequenzen, die zwischen 200 und 300 kHz liegen. Das Mikrosieb 63 ist zwischen der Membran 47 und dem Düsengrundkörper 62 eingespannt und verhindert, daß Partikel, die größer als 5 µm sind, und die unbeabsichtigt mit der Abdeckflüssigkeit mitgeführt werden, in das zur Düse führende Kanalsystem eintreten. Hier hilft die über das Mikrosieb 63 im Eintrittsbereich der Flüssigkeit geführte Membran 47 und die in diese eingeleitete Ultraschallschwingung eine Blockade des Mikrosiebes 63 durch sich verhakende Pigmente oder Kristalle zu vermeiden. Um eine möglichst große Filterfläche des Mikrosiebes 63 auszunutzen, wird dieses von einem System sehr kleiner feingefräster Stützkanäle 64 gehalten. Die Abdeckflüssigkeit wird durch die Versorgungsleitung 22 der Düse 2 zugeleitet. Diese Versorgungsleitung 22 ist mittels einer Überwurfmutter 65 auf ein Klemmstück 66 dicht aufgesetzt.

Über eine Luft- Wasserversorgungsleitung 67 wird die für die Reinigung und die Trocknung der Düse 2 erforderliche Flüssigkeit bzw. die notwendige Luft der Düse 2 im Bedarfsfall zugeführt. Auch diese Leitung 67 wird mit einer Überwurfmutter 68 gegen ein Einschraubklemmstück 69 gepreßt. Die Leitung 67 führt zu einem Umschaltventil 70, welches hier symbolisch dargestellt ist und sich in einer größeren Entfernung von der Düse 2 befindet.

In Figur 8 ist zu erkennen, daß das Piezoelement 48 innerhalb des Gehäuses 52 durch zwei kurze Gewindestifte 71 in einer Symmetrielage relativ zum Gehäuse 52 gehalten wird.

Die in den Figuren 3 bis 8 beschriebenen Elektrostatikdüsen eignen sich in besonderer Weise dazu, das erfindungsgemäße Verfahren durchzuführen, da sich mit ihnen auch eine hochviskose bzw. zähe Abdeckflüssigkeit tropfenweise auf den Zylinder aufspritzen läßt, ohne daß dazu die Baulänge der Düse und damit die Abmessungen der Vorrichtung zur Durchführung des Verfahrens extrem große Werte annehmen müssen.

## Patentansprüche

1. Verfahren zur Herstellung von Flexodruckformen, bei dem
- auf die Oberfläche einer Fotoelastomerschicht (1d), die auf der Oberfläche eines Zylinders (1) liegt, eine Abdeckflüssigkeit durch eine oder mehrere Düsen (2) bei Drehung des Zylinders (1) um seine Zylinderachse (1b) sowie unter Verschiebung der Düse (2) parallel zur Zylinderachse (1b) entlang einer Schraubenlinie aufgespritzt wird, um die Oberfläche der Fotoelastomerschicht (1d) mit einem Muster (1a) zu bedecken,
- die Fotoelastomerschicht (1d) anschließend belichtet wird, um ihre nicht vom Muster (1a) bedeckten Bereichen durch die Belichtung zu vernetzten, und
- sodann die unbelichteten Bereiche der Fotoelastomerschicht (1d) ausgewaschen werden.

2. Verfahren nach Anspruch 1, **dadurch gekennzeichnet**, daß die Abdeckflüssigkeit in mehreren Schichten aufgebracht wird.

3. Verfahren nach Anspruch 1 oder 2, **dadurch gekennzeichnet**, daß eine Metallpigmente enthaltende Abdeckflüssigkeit aufgebracht wird.

4. Verfahren nach Anspruch 3, **dadurch gekennzeichnet**, daß als Abdeckflüssigkeit eine Silberhalogenidemulsion aufgebracht wird.

5. Verfahren nach Anspruch 4, **dadurch gekennzeichnet**, daß die Silberhalogenidemulsion Silberbromid, Silberjodid und/oder Silberchlorid in Gelatine oder Polyvinylalkohol enthält.

6. Verfahren nach Anspruch 4 oder 5, **dadurch gekennzeichnet**, daß die Emulsion vorbelichtet wird.

7. Verfahren nach einem der Ansprüche 4 bis 6, **dadurch gekennzeichnet**, daß die Silberhalogenidemulsion nach Aufbringen auf die Fotoelastomerschicht (1d) zunächst chemisch entwickelt wird.

8. Verfahren nach einem der Ansprüche 1 bis 7, **dadurch gekennzeichnet,** daß die Abdeckflüssigkeit unter einer Richtung aus der Düse (2) ausgespritzt wird, die wenigstens annähernd parallel zur Erdanziehungskraft verläuft.

9. Verfahren nach einem der Ansprüche 1 bis 8, **dadurch gekennzeichnet**, daß als Düse (2) eine Elektrostatikdüse verwendet wird.

10. Verfahren nach einem der Ansprüche 1 bis 9, **dadurch gekennzeichnet**, daß das Aufspritzen der Abdeckflüssigkeit unter Begleitung eines sie umgebenden, laminaren Gasstroms erfolgt.

11. Verfahren nach Anspruch 10, **dadurch gekennzeichnet**, daß der Gasstrom ein Luft- oder Inertgasstrom ist.

12. Verfahren nach Anspruch 10 oder 11, **dadurch gekennzeichnet,** daß der laminare Gasstrom eine gegenüber der Umgebungstemperatur erhöhte Temperatur aufweist.

13. Verfahren nach einem der Ansprüche 1 bis 14, **dadurch gekennzeichnet,** daß der Träger bzw. Zylinder (1) wenigstens im Auftreffpunkt der Abdeckflüssigkeit beheizt wird.

## Claims

1. Process for producing flexographic printing plates, in which
- a covering liquid is sprayed through one or more nozzles (2), along a helical line, onto the surface of a photoelastomer layer (1d) , which lies on the surface of a cylinder (1), while the cylinder (1) is rotated about its cylinder axis (1b) and while the nozzle (2) is displaced parallel to the cylinder axis (1b), in order to cover the surface of the photoelastomer layer (1d) with a pattern (1a),
- the photoelastomer layer (1d) is then exposed in order as a result of the exposure to cross-link its regions that are not covered by the pattern (1a), and
- the unexposed regions of the photoelastomer layer (1d) are then washed out.

2. Process according to Claim 1, characterized in that the covering liquid is applied in several layers.

3. Process according to Claim 1 or 2, characterized in that a covering liquid containing metal pigments is applied.

4. Process according to Claim 3, characterized in that the covering liquid applied is a silver halide emulsion.

5. Process according to Claim 4, characterized in that the silver halide emulsion contains silver bromide, silver iodide and/or silver chloride in gelantine [sic] or polyvinyl alcohol.

6. Process according to Claim 4 or 5, characterized in that the emulsion is pre-exposed.

7. Process according to one of Claims 4 to 6, characterized in that, after being applied to the photoelastomer layer (1d), the silver halide emulsion is firstly chemically developed.

8. Process according to one of Claims 1 to 7, characterized in that the covering liquid is sprayed out of the nozzle (2) in a direction which runs at least approximately parallel to the force of gravity.

9. Process according to one of Claims 1 to 8, characterized in that the nozzle (2) used is an electrostatic nozzle.

10. Process according to one of Claims 1 to 9, characterized in that the spraying of the covering liquid is carried out with the accompaniment of a laminar gas stream that surrounds the liquid.

11. Process according to Claim 10, characterized in that the gas stream is an air or inert-gas stream.

12. Process according to Claim 10 or 11, characterized in that the laminar gas stream has a temperature that is elevated above the ambient temperature.

13. Process according to one of Claims 1 to 14, characterized in that the carrier or cylinder (1) is heated, at least at the point of incidence of the covering liquid.

## Revendications

1. Procédé de fabrication de plaques d'impression flexographique, dans lequel
- sur la surface d'une couche en photo-élastomère (1d), placée sur la surface d'un cylindre (1), est appliqué par pulvérisation un liquide de recouvrement, au moyen d'une ou plusieurs buses (2), par rotation du cylindre (1) autour de son axe de cylindre (1b) ainsi que par déplacement de la buse (2) parallèlement à l'axe de cylindre (1b), le long d'une ligne hélicoïdale, pour recouvrir la surface de la couche de photoélastomère (1d) d'un motif ou patron (1a).
- la couche en photoélastomère (1d) est ensuite illuminée, pour réticuler par l'illumination les zones n'ayant pas été recouvertes par le motif (1a), et
- ensuite, les zones non-illuminées de la couche en photoélastomère (1d) sont éliminées par lavage.

2. Procédé selon la revendication 1, caractérisé en ce que le liquide de recouvrement est appliqué en plusieurs couches.

3. Procédé selon la revendication 1 ou 2, caractérisé en ce qu'un liquide de recouvrement contenant des pigments métalliques est appliqué.

4. Procédé selon la revendication 3, caractérisé en ce qu'on applique à titre de liquide de recouvrement une émulsion d'halogénure d'argent.

5. Procédé selon la revendication 4, caractérisé en ce que l'émulsion d'halogénure d'argent contient du bromure d'argent, de l'iodure d'argent et/ou du chlorure d'argent. dans de la gélatine ou de l'alcool polyvinylique.

6. Procédé selon la revendication 4 ou 5, caractérisé en ce que l'émulsion est pré-illuminée.

7. Procédé selon l'une des revendications 4 à 6, caractérisé en ce que l'émulsion d'halogénure d'argent est d'abord soumise à un développement chimique après application sur la couche en photo-élastomère (1d).

8. Procédé selon l'une des revendications 1 à 7. caractérisé en ce que le liquide de recouvrement est appliqué par pulvérisation. à partir de la buse (2), dans une direction qui s'étend au moins à peu près parallèlement à la direction de la force d'attraction terrestre.

9. Procédé selon l'une des revendications 1 à 8, caractérisé en ce qu'on utilise comme buse (2) une buse électrostatique.

10. Procédé selon l'une des revendications 1 à 9, caractérisé en ce que l'application par pulvérisation du liquide de recouvrement s'effectue en l'accompagnant d'un flux de gaz laminaire qui l'entoure.

11. Procédé selon la revendication 10, caractérisé en ce que le flux de gaz est un flux d'air ou un flux de gaz inerte.

12. Procédé selon la revendication 10 ou 11, caractérisé en ce que le flux de gaz laminaire présente une température augmentée par rapport à la température ambiante.

13. Procédé selon l'une des revendications 1 à 14, caractérisé en ce que le support ou le cylindre (1) est chauffé au moins au point d'impact du liquide de recouvrement.
